# EUROPÄISCHE PATENTANMELDUNG

(11) **EP 1 302 894 A2**
(43) Veröffentlichungstag der Anmeldung: **16.04.2003**
(21) Anmeldenummer: 02021158.7
(22) Anmeldetag: 24.09.2002
(51) Int. Cl.: G06K 19/077

(54) **Kontaktlose Chipkarte und Herstellungsverfahren**

(30) Priorität: 12.10.2001 DE 10150205; 09.01.2002 DE 10200569
(71) Anmelder: Multitape GmbH, 33154 Salzkotten (DE)
(72) Erfinder: Reutner, Ulrich, 69226 Nussloch (DE); Wendisch, Karl-Heinz, 33154 Salzkotten (DE)
(74) Vertreter: Paul, Dieter-Alfred, Dipl.-Ing.

(57) **Zusammenfassung**

Chipkarte mit einer Mehrzahl von aneinanderliegenden und durch Wärme und Druck miteinander verbundenen Kartenschichten, wobei eine innere Trägerschicht an einer Oberseite derselben eine Antennenspule mit einer Mehrzahl von Leiterbahnen und an den Enden derselben angeordnete Spulenpads einerseits und eine Ausnehmung zur Aufnahme eines Chipmoduls andererseits aufweist, dass die Spulenpads in einem Kontaktierungsbereich zu beiden Seiten eines durch die nebeneinander verlaufenden Leiterbahnen gebildeten Leiterbahnabschnitts angeordnet sind, wobei die Ausnehmung in dem Leiterbahnabschnitt angeordnet ist, derart, dass das Chipmodul unter direkter Anlage von Chipanschlüssen desselben an den Spulenpads der Antennenspule in die Ausnehmung einsetzbar ist.

## Beschreibung

Die Erfindung betrifft eine Chipkarte mit einer Mehrzahl von aneinanderliegenden und durch Wärme und Druck miteinander verbundenen Kartenschichten, wobei eine innere Trägerschicht an einer Oberseite derselben eine Antennenspule mit einer Mehrzahl von Leiterbahnen und an den Enden derselben angeordnete Spulenpads einerseits und eine Ausnehmung zur Aufnahme eines Chipmoduls andererseits aufweist, dass die Spulenpads in einem Kontaktierungsbereich zu beiden Seiten eines durch die nebeneinander verlaufenden Leiterbahnen gebildeten Leiterbahnabschnitts angeordnet sind.

Ferner betrifft die Erfindung ein Herstellungsverfahren für eine Trägerschicht, in der sowohl eine Antennenspule als auch ein Chipmodul integriert ist.

Aus der DE 196 40 260 A1 ist eine Chipkarte mit einer eine Antennenspule tragenden Trägerschicht bekannt, wobei zur Kontaktierung von Spulenpads der Antennenspule mit ortsfern angeordneten Chipanschlüssen des Chipmoduls über sogenannte Leadframes elektrisch leitend verbunden sind. Zu diesem Zweck weisen die Spulenpads jeweils Durchbrüche auf, durch die Enden des Leadframes hindurchführbar, umlenkbar und nachfolgend durch Bildung von Schweißpunkten flächig auf den Spulenpads elektrisch und mechanisch verbindbar sind.

Aufgabe der vorliegenden Erfindung ist es, eine Chipkarte und ein Herstellungsverfahren für eine Trägerschicht derart anzugeben, dass die Kontaktierung zwischen den Spulenpads der Antennenspule einerseits und den Chipanschlüssen des Chipmoduls andererseits vereinfacht wird.

Zur Lösung dieser Aufgabe ist die erfindungsgemäße Chipkarte dadurch gekennzeichnet, dass die Ausnehmung in dem Leiterbahnabschnitt angeordnet ist, wobei die Leiterbahnen die das Chipmodul enthaltende Ausnehmung unter direkter Anlage an dem Chipmodul überstreichen.

Zur Lösung der Aufgabe wird erfindungsgemäß ein Herstellungsverfahren gemäß Anspruch 9 und 11 vorgeschlagen.

Der besondere Vorteil der erfindungsgemäßen Chipkarte bzw. der Trägerschicht besteht darin, dass eine direkte und unmittelbare Kontaktierung der Chipanschlüsse des Chipmoduls mit den Spulenpads der Antennenspule ermöglicht wird. Der Einsatz von zusätzlichen Bauteilen zur Kontaktierung oder der Einsatz von Kontaktierungsbrücken zur Überbrückung eines Spulenpads von einer Seite des Leiterbahnabschnitts zu der gegenüberliegenden Seite des Leiterbahnabschnitts, in der der andere Spulenpad angeordnet ist, ist nicht erforderlich. Grundgedanke der Erfindung ist es, die Ausnehmung unmittelbar im Leiterbahnabschnitt auszuformen, so dass eine direkte Anlage des Chipmoduls an den Leiterbahnen des Leiterbahnabschnitts sowie eine direkte Kontaktierung der Chipanschlüsse an den Spulenpads ermöglicht wird.

Vorteilhaft liegen die Leiterbahnen bzw. Spulenpads unmittelbar nach dem Aufbringen auf die Trägerschicht frei auf derselben vor, so dass ohne zusätzliche Maßnahmen eine direkte Kontaktierung mit dem Chipmodul ermöglicht wird. Dabei liegen die die Ausnehmung überspannenden Leiterbahnen unmittelbar auf einer Seite des Chipmoduls auf, so dass deren Lage stabilisiert ist. Die Leiterbahnen erstrecken sich in einem gleichmäßigen Abstand zueinander über die Ausnehmung, wobei unter Mitberücksichtigung der durch die Spulenpads abgedeckten Fläche der Ausnehmung mehr als 50 % der Gesamtfläche der Ausnehmung abgedeckt ist und damit nicht freiliegt.

Nach einer bevorzugten Ausführungsform der Erfindung ist der Abstand zwischen den Chipanschlüssen gleich dem Abstand zwischen den Spulenpads, so dass die auf einer den Leiterbahnen zugewandten Oberseite des Chipmoduls angeordneten Chipanschlüssen in der Kontaktierungsposition unmittelbar an den Spulenpads anliegen.

Nach einer Weiterbildung der Erfindung ist das Chipmodul als Vergusskörper, insbesondere als vergossenes SMD-Bauteil (Surface Mounted Device-Bauteil) ausgebildet ist, in dem der Chip angeordnet ist. Vorteilhaft kann hierdurch auf bewährte Konfektionierungstechniken der Halbleiterherstellung zurückgegriffen werden.

Nach einer Weiterbildung der Erfindung ist das Chipmodul in der Ausnehmung bündig zu der Oberseite und/oder der Unterseite der Trägerschicht ausgerichtet. Bei vollständig bündiger Ausrichtung ergibt sich somit eine Trägerfolie mit annähernd flächigen Seiten. Lediglich die Leiterbahnen und die Spulenpads stehen von einer Oberseite der Trägerschicht bzw. des Chipmoduls ab.

Nach einer Weiterbildung der Erfindung werden die Spulenanschlüsse mittels eines leitfähigen Klebers an den Spulenpads elektrisch leitend und mechanisch verbunden. Hierdurch entsteht eine Trägerfolie, die nicht nur die Antennenspule, sonder auch das Chipmodul trägt. Vorteilhaft ergibt sich hierdurch ein einfach hergestelltes Halbzeug, das eine problemlose Weiterverarbeitung zu einer Chipkarte ermöglicht.

Die erfindungsgemäßen Verfahren ermöglichen auf einfache Weise die Herstellung einer Trägerschicht für eine Antennenspule sowie ein Chipmodul.

Ein Ausführungsbeispiel der Erfindung wird nachfolgend anhand der Zeichnungen näher erläutert.

Es zeigen:
- Figur 1: einen Teilschnitt durch eine Chipkarte in einem Kontaktierungsbereich und
- Figur 2: eine teilweise Draufsicht auf eine Trägerschicht mit einer Antennenspule und einem Chipmodul im Kontaktierungsbereich.

Eine Chipkarte 1 mit einem dreischichtigen Aufbau besteht im Wesentlichen aus einer inneren Trägerschicht 2 (Kernschicht) und zu beiden Seiten der Trägerschicht 2 sich anschließenden Deckschichten 3. Die Deckschichten 3 und die Trägerschicht 2 werden in einem Laminierprozess durch Aufbringen von Wärme und Druck fest miteinander verbunden.

Die Trägerschicht 2 weist auf einer Oberseite 4 eine mit mehreren Windungen versehene Antennenspule 5 auf. In einem Kontaktierungsbereich 6 der Antennenspule 5 weisen die Enden der im Wesentlichen kreis- oder polygonförmig angeordneten und die Antennenspule 5 bildenden Leiterbahnen 7 verbreiterte Spulenpads 8 auf. Zwischen den Spulenpads 8 erstrecken sich in der gleichen Ebene eine Mehrzahl von Leiterbahnen 7, im vorliegenden Ausführungsbeispiel vier Leiterbahnen. Die Spulenpads 8 begrenzen somit den breitesten Leiterbahnabschnitt der Antennenspule 5. Zwischen den Spulenpads 8 erstrecken sich alle Windungen der Antennenspule 5.

In dem so zwischen den Spulenpads 8 angeordneten Leiterbahnabschnitt weist die Trägerschicht 2 eine Ausnehmung 9 zur Aufnahme eines Chipmoduls 10 auf. Die Form der Ausnehmung 9 korrespondiert zur Form des Chipmoduls 10. Auf einer den Leiterbahnen 7 zugeordneten Oberseite 11 des Chipmoduls 10 sind randseitig jeweils Chipanschlüsse 12 ausgebildet, die in der vorgesehenen Kontaktierungsposition des Chipmoduls 10 unmittelbar an den jeweiligen Spulenpads 8 anliegen. Eine elektrisch leitende und mechanische Verbindung zwischen den Chipanschlüssen 12 einerseits und den Spulenpads 8 kann durch Vorsehen eines elektrisch leitenden Klebers bewirkt werden.

Die Breite der Ausnehmung 9 ist derart gestaltet, dass ein Teilbereich des Spulenpads 8 untenseitig zur Anlage an die Chipanschlüsse 12 frei liegt. Ein weiterer, außen liegender Teilbereich der Spulenpads 8 ist unmittelbar mit der Trägerschicht 2 verbunden.

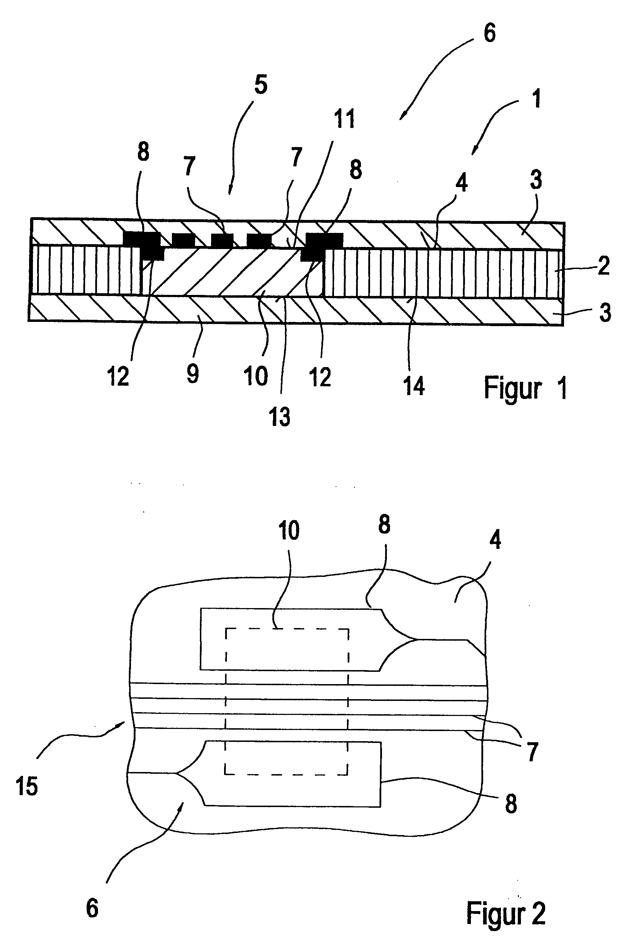

In dem vorliegenden Ausführungsbeispiel ist sowohl die Oberseite 11 des Chipmoduls 10 als auch eine Unterseite 13 des Chipmoduls 10 bündig zu der Oberseite 4 der Trägerschicht 2 bzw. eine Unterseite 15 der Trägerschicht 2 ausgerichtet. Nach Einsetzen bzw. Kontaktierung des Chipmoduls 10 in der Ausnehmung 9 ist die Trägerschicht 2 zu beiden Seiten flächig ohne wesentliche Erhabenheiten ausgebildet. Auf diese Weise kann eine einfache Weiterverarbeitung zu einer Chipkarte erfolgen. Die Erhabenheit der Leiterbahnen 7 bzw. der Spulenpads 8 in Figur 2 sind zur Verdeutlichung überdimensioniert dargestellt. Ihre Dicke ist im Vergleich zur Dicke der Trägerschicht 2 vergleichsweise gering.

Das Chipmodul 10 ist als Vergusskörper, insbesondere als vergossenes SMD-Bauteil (Surface-Mounted-Device-Bauteil) ausgebildet, in dem der Chip angeordnet ist. Zwischen dem Chip und den Chipanschlüssen 12 ist eine leitende Verbindung.

Im Folgenden wird die Herstellung der Trägerschicht 2, die vorzugsweise ein Zwischenprodukt darstellen kann beschrieben.

Die Trägerschicht 2 kann als eine Trägerfolie bestehend aus Polyester, Polyvinylchlorid (PVC), Polycarbonat (PC), Polyethylenterephthalat (PET), Polymethylmethacrylat (PMMA), PEN oder als ein glasfaserverstärkter Kunststoff ausgebildet sein.

Nach einer ersten Ausführungsform eines Herstellungsverfahrens wird in dem Kontaktierungsbereich 6 der Trägerschicht 2 die Ausnehmung 9 gebildet. Nachfolgend wird in die Ausnehmung 9 das Chipmodul 10 unter bündigem Abschluss zu beiden Seiten der Trägerfolie 2 eingesetzt. In einem weiteren Schritt wird nun auf der Oberseite 4 der Trägerschicht 2 die Antennenspule 5 verlegt, wobei Spulenpads 8 korrespondierend zu den Chipanschlüssen 12 positioniert werden. Die zwischen den Spulenpads 8 angeordneten Leiterbahnen 7 liegen unmittelbar an der Oberseite 11 des Chipmoduls 10 an. Die elektrische Kontaktierung und mechanische Verbindung zwischen der Trägerfolie 2 bzw. den Spulenpads 8 und den Chipanschlüssen 12 erfolgt durch Anwendung eines elektrisch leitenden Klebers. Somit ist die Trägerschicht als Halbzeug fertiggestellt und kann zur Herstellung einer Chipkarte 1 nach einem bekannten Verfahren weiterverarbeitet werden.

Nach einem zweiten Herstellungsverfahren wird zuerst die Antennenspule 5 auf die Oberseite 4 der Trägerschicht 2 unter Bildung von Spulenpads 8 aufgebracht. Dies kann mittels eines bekannten Ätzvorganges oder durch Aufwickeln der Antennenspule 5 erfolgen. Nachfolgend wird von der Unterseite 14 der Trägerschicht 2 die Ausnehmung 9 durch Ausfräsen gebildet, und zwar so weit, bis zumindest teilweise die Spulenpads 8 von der Rückseite her freigelegt sind. Nachfolgend kann von der Unterseite her das Chipmodul 10 unter direkter Anlage der Chipanschlüsse 12 an die Spulenpads 8 eingesetzt werden. Vorzugsweise wird die Kontaktierung zwischen den Chipanschlüssen 12 einerseits und den Spulenpads 8 andererseits durch einen elektrisch leitenden Kleber bewirkt. Die Trägerschicht 2 ist nunmehr Träger für die Antennenspule 5 und das Chipmodul 10 und kann auf oben beschriebene Weise zu einer Chipkarte 1 weiterverarbeitet werden.

## Patentansprüche

1. Chipkarte mit einer Mehrzahl von aneinanderliegenden und durch Wärme und Druck miteinander verbundenen Kartenschichten, wobei eine innere Trägerschicht an einer Oberseite derselben eine Antennenspule mit einer Mehrzahl von Leiterbahnen und an den Enden derselben angeordnete Spulenpads einerseits und eine Ausnehmung zur Aufnahme eines Chipmoduls andererseits aufweist, dass die Spulenpads in einem Kontaktierungsbereich zu beiden Seiten eines durch die nebeneinander verlaufenden Leiterbahnen gebildeten Leiterbahnabschnitts angeordnet sind, **dadurch gekennzeichnet, dass** die Ausnehmung (9) in dem Leiterbahnabschnitt (15) angeordnet ist, wobei die Leiterbahnen (7) die das Chipmodul (10) enthaltende Ausnehmung (9) unter direkter Anlage an dem Chipmodul (10) überstreichen.

2. Chipkarte nach Anspruch 1, **dadurch gekennzeichnet, dass** die Leiterbahnen (7) freiliegend auf dem Chipmodul angeordnet sind.

3. Chipkarte nach Anspruch 1 oder 2, **dadurch gekennzeichnet, dass** die Leiterbahnen (7) als auf die Trägerschicht (2) verlegte oder gewickelte oder geätzte Leiterbahnen (7) in dem Leiterbahnabschnitt (15) unmittelbar auf dem Chipmodul (10) aufliegen.

4. Chipkarte nach einem der Ansprüche 1 bis 3, **dadurch gekennzeichnet, dass** die Chipanschlüsse (12) des Chipmoduls (10) direkt an den Spulenpads (8) der Antennenspule (5) anliegen, wobei die Chipanschlüsse (12) auf einer der Oberseite (4) der Trägerschicht (2) zugekehrten Oberseite (11) des Chipmoduls (10) in einem solchen Abstand zueinander angeordnet sind, der zu dem Abstand der Spulenpads (8) zueinander korrespondiert.

5. Chipkarte nach einem der Ansprüche 1 bis 4, **dadurch gekennzeichnet, dass** das Chipmodul (10) als Vergusskörper, insbesondere als SMD-Bauteil, ausgebildet ist, dessen Oberseite (11) und/oder dessen Unterseite (13) bündig zu der Oberseite (4) der Trägerschicht (2) bzw. der Unterseite (14) der Trägerschicht (2) ausgerichtet ist.

6. Chipkarte nach einem der Ansprüche 1 bis 5, **dadurch gekennzeichnet, dass** die Chipanschlüsse (12) mittels eines Leitklebers mit den korrespondierenden Spulenpads (8) elektrisch leitend und mechanisch verbunden sind.

7. Chipkarte nach einem der Ansprüche 1 bis 6, **dadurch gekennzeichnet, dass** die Trägerschicht (2) aus Polyethylen oder Polycarbonat oder PVC oder PEN hergestellt ist.

8. Verwendung einer Kernschicht nach einem der Ansprüche 1 bis 5 als eine Trägerfolie zur Aufnahme der Antennenspule (5) und des Chipmoduls (10).

9. Verfahren zur Herstellung einer Trägerschicht nach einem der Ansprüche 1 bis 7, wobei in die Ausnehmung (9) der Trägerschicht (2) das Chipmodul (10) positioniert und dann auf der Oberseite (4) der Trägerschicht (2) die Antennenspule (5) aufgebracht wird.

10. Verfahren nach Anspruch 9, **dadurch gekennzeichnet, dass** die Antennenspule (5) durch Verlegen auf die Trägerschicht (2) aufgebracht wird.

11. Verfahren zur Herstellung einer Trägerschicht nach einem der Ansprüche 1 bis 7, wobei zuerst die Antennenspule (5) auf die Oberseite (4) der Trägerschicht (2) aufgebracht wird, nachfolgend die Ausnehmung (9) von einer Unterseite (14) der Trägerschicht (2) ausgefräst wird und dann das Chipmodul (10) unter Anlage an den Leiterbahnabschnitt in die Ausnehmung (9) eingesetzt wird.

12. Verfahren nach Anspruch 11, **dadurch gekennzeichnet, dass** die Antennenspule (5) durch Ätzen oder als aufgewickelte Antennenspule (5) auf die Trägerschicht (2) aufgebracht wird.
